# EUROPEAN PATENT SPECIFICATION

(11) **EP 1 860 685 B1**
(45) Date of publication and mention of the grant of the patent: **19.07.2017**
(21) Application number: 06712113.7
(22) Date of filing: 20.01.2006
(51) Int. Cl.: C23C 16/54, H01L 21/02, H01L 31/18, C23C 16/40, C23C 16/455

(54) **TRANSPARENT CONDUCTIVE FILM FORMING APPARATUS, MULTILAYER TRANSPARENT CONDUCTIVE FILM CONTINUOUSLY FORMING APPARATUS AND METHOD OF FILM FORMING THEREWITH**
VORRICHTUNG ZUR BILDUNG EINES TRANSPARENTEN LEITFÄHIGEN FILMS, VORRICHTUNG ZUM KONTINUIERLICHEN BILDEN EINES MEHRSCHICHTIGEN TRANSPARENTEN LEITFÄHIGEN FILMS UND VERFAHREN ZUR FILMERZEUGUNG DAMIT
DISPOSITIF DE FORMATION D'UN FILM CONDUCTEUR TRANSPARENT, DISPOSITIF DE FORMATION EN CONTINU D'UN FILM CONDUCTEUR TRANSPARENT MULTICOUCHE ET PROCÉDÉ DE FORMATION D'UN FILM À L'AIDE DE CE DERNIER

(30) Priority: 21.01.2005 JP 2005013682
(43) Date of publication of application: 28.11.2007
(73) Proprietor: Solar Frontier K.K., Minato-ku Tokyo 135-8074 (JP)
(72) Inventor: TANAKA, Yoshiaki, Minato-ku, Tokyo 135-8074 (JP)
(74) Representative: Hoffmann Eitle
(86) International application number: PCT/JP2006/300888
(87) International publication number: WO 2006/077986

(56) References cited:
- WO-A1-91/17839
- JP-A- 04 067 617
- JP-A- 08 236 456
- JP-A- 2001 023 907
- JP-A- 2005 501 182
- US-A1- 2004 067 641
- US-A1- 2004 149 211
- US-B1- 6 298 685
- US-B1- 6 331 260

## Description

### TECHNICAL FIELD

The present invention relates to a film deposition apparatus for the continuous production of a transparent conductive film having a multilayer structure by the MOCVD method.

### BACKGROUND ART

The sputtering method and the metal-organic chemical vapor deposition (MOCVD) method are used in the step of forming a transparent conductive film among solar cell production steps. Reactions in the MOCVD method proceed at low temperatures (200 deg. C or lower) and it is a chemical vapor deposition method. Because of these, the MOCVD method is a mild film deposition technique which causes no mechanical damage to other thin constituent layers unlike the techniques in which the bombardment of energy particles damages underlying thin constituent layers, such as the sputtering method.

In producing a CIGS type thin-film solar cell, a transparent conductive film is formed over thin constituent layers on the light incidence side thereof. The transparent conductive film formed by the MOCVD method has the function of enhancing the effect (function) of the buffer layer. In the case of the sputtering method, however, the transparent conductive film is known to cause damage to the buffer layer, rather than enhances its effect, and to reduce the performances of the solar cell.

Techniques for forming a transparent conductive film by the MOCVD method have been disclosed (see, for example, patent documents 1 and 2). The techniques disclosed therein comprise heating a substrate on a heated support, evacuating the chamber and allowing the substrate to stand therein for about 20 minutes to make the temperature thereof even, and then conducting film deposition for about 30 minutes by the MOCVD method to thereby deposit a transparent conductive film in about 1 µm. An MOCVD-method film deposition apparatus is described in patent document 3. It has a constitution in which gases are introduced into a quartz reaction tube through a gas introduction opening and gases in the reaction tube are discharged through a gas discharge opening. This reaction tube has a susceptor made of carbon disposed therein, and a substrate is set on this susceptor. This apparatus has a structure in which the susceptor and the substrate are inductively heated with a high-frequency coil disposed outside the reaction tube. In this film deposition apparatus, an alkylaluminum is mainly used as an organometallic compound to be applied to the substrate. This MOCVD-method film deposition apparatus is not one for continuously forming a transparent conductive film having a multilayer structure, and has had a problem that it cannot form a transparent conductive film having a large area. On the other hand, an apparatus for the continuous formation of a thin semiconductor film has been disclosed in which two or more reaction chambers are disposed and film deposition is successively conducted therein (see, for example, patent document 4). However, this apparatus for continuous film deposition is not one for forming a transparent conductive film by the MOCVD method but one for forming a thin semiconductor film. There has been problem that it is difficult to directly divert such an apparatus for continuously forming a thin semiconductor film to the continuous formation of a transparent conductive film by the MOCVD method.

Patent Document 1: JP-B-6-14557
Patent Document 2: JP-A-6-209116
Patent Document 3: JP-A-2-122521
Patent Document 4: Japanese patent No. 2842551

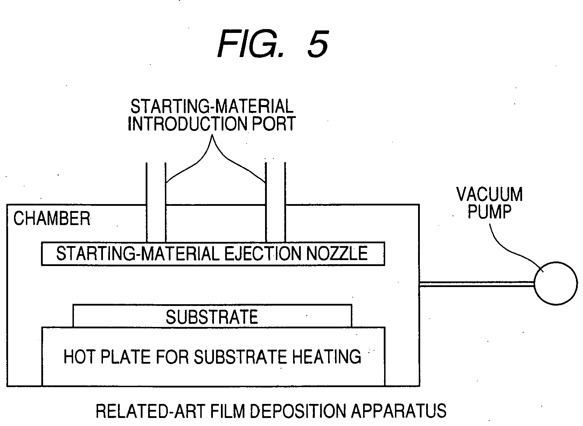

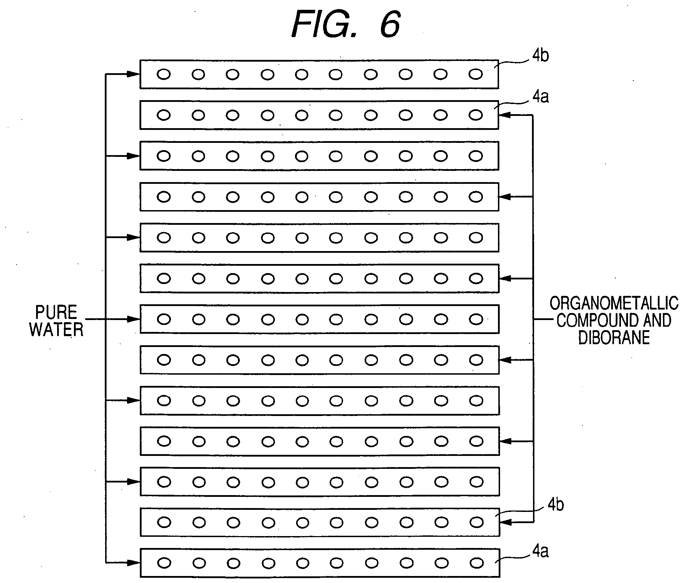

Furthermore, the related-art MOCVD-method film deposition apparatus include an MOCVD-method film deposition apparatus for an alkylzinc such as that shown in Fig. 5, and nozzles for exclusive use in this apparatus such as those shown in Fig. 6 have been employed.

This apparatus is an apparatus for the batch treatment of substrates. First, the chamber is opened in the air in order to introduce a substrate (hereinafter, a structure comprising a substrate and layers necessary for a CIGS type thin-film solar cell other than a transparent conductive film, which include a light absorption layer and a buffer layer, formed thereon is referred to as substrate). After a substrate is placed on the hot plate, the chamber is brought into a vacuum state. After the substrate has been heated to a set temperature, raw materials (e.g., an organometallic compound, e.g., diethylzinc zn(C₂H₅)₂, diborane B₂H₆, and pure water H₂O) are introduced through raw-material introduction ports. A carrier gas is used to spray these raw materials over the substrate through nozzles respectively corresponding to the raw materials. A transparent conductive film is deposited on the substrate over a certain time period (in a certain thickness) . Thereafter, the feeding of the raw materials is stopped. The chamber is then opened in the air (the internal pressure is returned to atmospheric pressure) and the substrate is taken out. Since the process is a batch treatment, a next substrate is thereafter placed on the hot plate. Subsequently, the same operation as described above is repeated to thereby form a transparent conductive film on the substrate. This apparatus has had the following features 1 to 3.
1. A feature of the nozzles resides in the structure which evenly sprays the organometallic compound, diborane, and pure water in a vacuum, as shown in Fig. 6. There has been a problem that nozzle maintenance is necessary because the temperature of the nozzles rises during growth due to the heat emitted from the hot plate and a deposit accumulates on the nozzles. Furthermore, there has been a problem that since the related-art nozzle structure has spaces between the ejection parts for an organometallic compound, water, and diborane, product accumulation occurs on the back side of the nozzles and even on an upper part of the chamber, resulting in a low efficiency of utilization of the raw materials and the necessity of frequent maintenance.
2. Because a substrate is directly placed on a metallic hot plate in growing a transparent conductive film, the heat distribution of the hot plate directly leads to the distribution of the transparent conductive film. There has hence been a problem that in case where the hot plate has an uneven heat distribution, a transparent conductive film which is uneven in sheet resistance, etc. is formed.
3. The apparatus has only one chamber. There has hence been a problem that the rate of substrate treatment is low and the rate of film deposition is low.

US-A-2004/0149211 discloses a deposition apparatus for depositing a layer on a substrate such as a semiconductor wafer. The deposition apparatus includes a process chamber in which there is a susceptor configured to receive a substrate for depositing a thin layer thereon. The deposition apparatus also includes a showerhead on a side of the process chamber configured to receive reaction gases and to introduce the reaction gases into the process chamber. The showerhead may include a heating element therein for heating reaction gases prior to their introduction into the reaction chamber. The showerhead may comprise a housing, at least one inlet port through which the reaction gasses are received into the showerhead, and a spray plate adjacent to the process chamber through which reaction gasses are introduced into the process chamber. The showerhead may further comprise a cooling portion configured to cool an outer portion of the housing. This cooling portion may comprise a duct on an outer portion of the housing configured to allow a cooling fluid to circulate therethrough.

US-A-2004/0067641 discloses a cyclical layer deposition system which includes a processing chamber, at least one load lock chamber connected to the processing chamber and a plurality of gas ports configured to transmit one or more gas streams into the processing chamber. The system further includes a plurality of vacuum ports disposed on the processing chamber between the gas ports. The vacuum ports are configured to transmit the gas streams out of the processing chamber.

### DISCLOSURE OF THE INVENTION

### PROBLEMS THAT THE INVENTION IS TO SOLVE

A first object of the invention, which is for eliminating the problems described above, is to improve the efficiency of utilization of raw materials and to reduce the necessity of maintenance. A second object is to form a transparent conductive film having an even sheet resistance. A third object is to improve the rate of film deposition while maintaining high film quality.

### MEANS FOR SOLVING THE PROBLEMS

According to a first aspect, the present invention provides an apparatus comprising a film-deposition chamber for producing a transparent conductive film comprising an n-type semiconductor on a substrate by metal-organic chemical vapour deposition (MOCVD) in which an organometallic compound, diborane (B₂H₆) and water are reacted in a vapour phase while heating the substrate, the film-deposition chamber comprising:
a group of nozzles which are arranged in the same plane and comprise pipe-form nozzles having ejection holes for simultaneously or separately spraying the organometallic compound, diborane and pure water, the pipe-form nozzles being arranged adjacent to each other such that there is no space between them; and
a nozzle-cooling means comprising cooling pipes disposed between nozzles of the planar group of nozzles such that there is no space between the cooling pipes and the nozzles.

According to a second aspect, the present invention provides an in-line type film-deposition apparatus for the continuous production of a multilayered transparent conductive film, the apparatus comprising:
a substrate-attachment part comprising a setter for attaching a substrate thereto;
a charging part for evacuating the air around the substrate attached to the setter;
a multilayer deposition treatment part comprising two or more deposition treatment parts for forming a multilayered transparent conductive film comprising an n-type semiconductor on the substrate by metal-organic chemical vapour deposition (MOCVD) in which an organometallic compound, diborane (B₂H₆) and water are reacted in a vapour phase while heating the substrate;
a takeout part for returning the substrate having the multilayered transparent conductive film thereon to atmospheric pressure;
a substrate-detachment part for detaching the substrate having the multilayered transparent conductive film thereon from the setter; and
a setter-return part for returning the detached setter to the substrate-attachment part;
wherein:
   the apparatus is capable of conducting film-deposition while moving the substrate sequentially through said parts to form the multilayered transparent conductive film; and
   each deposition-treatment part comprises a group of nozzles which are arranged in the same plane and comprise pipe-form nozzles having ejection holes for simultaneously or separately spraying the organometallic compound, diborane and pure water, the pipe-form nozzles being arranged adjacent to each other such that there is no space between them; and
   each deposition-treatment part comprises a nozzle-cooling means which comprises cooling pipes disposed between nozzles of the planar group of nozzles such that there is no space between the cooling pipes and the nozzles.

Preferably the charging part comprises a substrate-preheating means and the takeout part comprises a substrate-cooling means.

Preferably the setter is a production jig for fixing the substrate and conveying it through each part of the apparatus, and the setter comprises a member which contains a thermally-conductive carbon composite, a nickel coating on the member and a pin for fixing the substrate.

### ADVANTAGES OF THE INVENTION

In the invention, each deposition treatment part in the multilayer deposition treatment part is equipped inside with a group of nozzles of a planar structure comprising pipe-form nozzles which have ejection holes formed on the ejection side thereof for simultaneously or separately spraying the three raw materials consisting of the organometallic compound, diborane, and pure water and are arranged adjacently to each other in the same plane without leaving a space between these, and is further equipped with a nozzle-cooling mechanism which cools the group of nozzles. Because of this constitution, the group of nozzles has a one-plate structure having no space between the nozzles. As a result, a reaction product can be prevented from accumulating on the nozzles and the efficiency of utilization of raw materials can be improved. Furthermore, the prevention of reaction product accumulation on the nozzles can further reduce the necessity of maintenance.

In the invention, the setter may be made of a member having high thermal conductivity (carbon composite) whose surface is coated with a metallic coating having high thermal conductivity and high mechanical strength (e.g., nickel deposit). This constitution enables an even transparent conductive film to be formed. Furthermore, by disposing pins for substrate fixing on the setter, a substrate having any desired size can be treated.

In the invention, the charging part and the takeout part may be equipped with a preheating mechanism and a substrate-cooling mechanism, respectively. These mechanisms, in combination with the two or more deposition treatment parts, enable a multilayered film to be formed at an improved film deposition rate without deteriorating film quality.

### BEST MODE FOR CARRYING OUT THE INVENTION

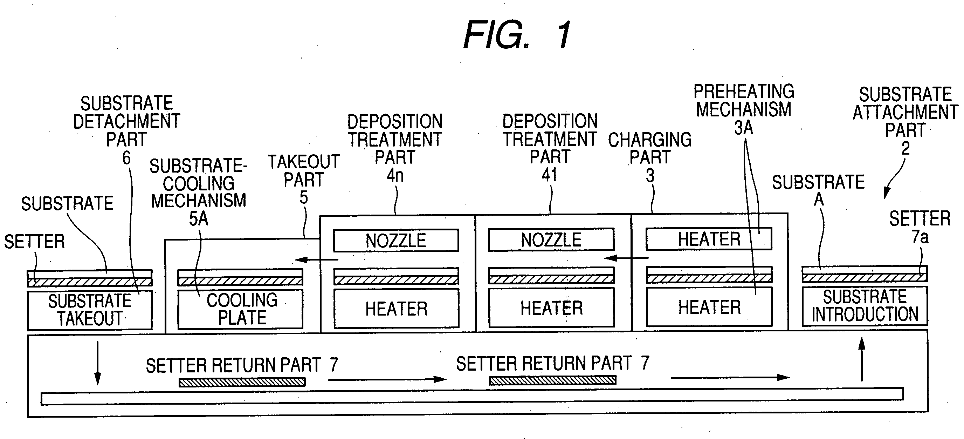

The invention provides a film deposition apparatus for continuously forming a multilayered transparent conductive film comprising a multilayered n-type semiconductor on a substrate and a method of the formation thereof. As shown in Fig. 1, this apparatus comprise a substrate attachment part 2 where a substrate A is attached to a setter 7a in the air, a chargingpart 3 where evacuation is conducted, a multilayer deposition treatment part 4 comprising two or more deposition treatment parts (41 to 4n) for forming a transparent conductive film comprising an n-type semiconductor (e.g., ZnO) on the heated substrate by the metal-organic chemical vapor deposition (MOCVD) method by reacting an organometallic compound (e.g., diethylzinc, Zn(C₂H₅)₂), diborane (B₂H₆), and water (water vapor) in a vapor phase while heating the substrate, a takeout part 5 where the substrate having the multilayered transparent conductive film is discharged into the air (the pressure is returned to the atmospheric pressure), a substrate detachment part 6 where the substrate A having the multilayered transparent conductive film is detached from the setter 7a, and a setter return part 7 where the setter 7a from which the substrate having the multilayered transparent conductive film was detached in the substrate detachment part is returned to the substrate attachment part 2. In this apparatus, film deposition is successively conducted while moving the substrate sequentially through the parts to form a multilayered transparent conductive film comprising a multilayered n-type semiconductor on the substrate.

In each of the deposition treatment parts 41 ··· 4n in the multilayer deposition treatment part 4 shown in Fig. 1, the following chemical reactions occur when a transparent conductive film made of ZnO is formed.

The main reactions are the following 1 and 2.
1.

   Zn (C₂H₅)₂ + 2H₂O → Zn(OH)₂ + 2C₂H₆
2.

   Zn(OH)₂ → ZnO + H₂O
Diborane (H₂H₆) is incorporated into the ZnO in a slight amount.

Specifically, the following reaction occurs :

Zn(C₂H₅)₂ + H₂O + nB₂H₆ → ZnO:B + 2C₂H₆ + nB₂O₃

provided that n is considerably small.

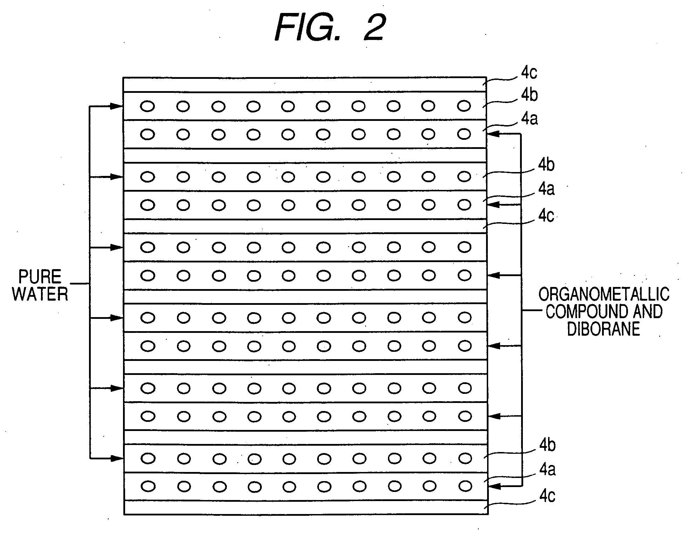

Each of the deposition treatment parts 41 ··· 4n in the multilayer deposition treatment part 4 shown in Fig. 1 is equipped with composite nozzles (group of nozzles) 4A which are in the platy form (one-plate structure) shown in Fig. 2 and spray the reactants undergoing the MOCVD reactions and which have a nozzle-cooling mechanism. The composite nozzles 4A each comprise a first nozzle 4a for spraying an organometallic compound and diborane, a second nozzle 4b for spraying pure water, and a cooling pipe 4c. The nozzles 4a and 4b and the pipe 4c are independent of one another. They each comprise a pipe having a nearly square sectional shape. The composite nozzles 4A have a flat-plate planar structure in which the first nozzles 4a, second nozzles 4b, and cooling pipes 4c are alternately arranged (disposed) closely in this order without leaving a space therebetween. The first nozzles 4a and the secondnozzles 4bhave small holes (ej ectionholes) h for spraying the respective reactants, the holes h being formed on the lower side (substrate disposition side) of the nozzles at a certain interval. Incidentally, the nozzles can be modified to the type in which the three reactants, i.e., an organometallic compound, diborane, and pure water, are simultaneously sprayed through the same nozzle or the type in which an organometallic compound, diborane, and pure water are sprayed separately. The sectional shape of the nozzles 4a and 4b and cooling pipes 4c may be another shape, e.g., circle, as long as the nozzles and pipes can be closely disposed without leaving a space therebetween. The cooling pipes shown are an example, and cooling pipes can be disposed in a smaller or larger number than that in the figure.

The cooling pipes 4c cool the nozzles 4a and 4b to inhibit an organometallic compound, diborane, and pure water, which are raw materials for film deposition, from reacting around the nozzles. Since the nozzles 4a and 4b and the cooling pipes 4c have a flat-plate (one-plate) structure in which they are closely disposed without leaving a space therebetween, the raw materials do not accumulate on the back side of the nozzles or an upper part of the chamber (the structure functions as an adhesion-preventive plate). Consequently, the amount of the rawmaterials to be used is reduced. The embodiment described above is one in which ZnO is deposited as a transparent conductive film. In the case of depositing aluminum oxide Al₂O₃, however, the organometallic compound to be used as a raw material is Al (CₙH₂ₙ₊₁)₃, preferably Al (CH₃)₃ or Al(C₂H₅)₃·

The setter 7a is a production jig for fixing a substrate and conveying it through each part in the film deposition apparatus, and is made of a member having high thermal conductivity (carbon composite) . For the purpose of enhancing the mechanical strength of the carbon material, which has low mechanical strength, a metallic coating having high thermal conductivity and high mechanical strength (e.g., nickel deposit) is applied to the surface thereof. Moreover, pins for substrate fixing .are disposed in order to enable the setter to accept a substrate of any size.

The charging part 3 is equipped with a preheating mechanism 3A for heating the substrate from above with a heater, and the takeout part 5 is equipped with a substrate-coolingmechanism 5A for cooling the substrate from below with a cooling plate.

Table 1 given below shows a comparison in the efficiency of utilization of raw materials for a transparent conductive film between the case where a transparent conductive film was formed with the composite nozzles 4A shown in Fig. 2 disposed in each of the deposition treatment parts 41 ··· 4n in the multilayer deposition treatment part 4 of a film deposition apparatus of the invention for the continuous formation of a multilayered transparent conductive film (hereinafter referred to as composite nozzles 4A according to the invention) and the case where a transparent conductive film was formed with the nozzles shown in Fig. 6 in a related-art film deposition apparatus.

**[Table 1]**

| Comparison in efficiency of raw-material utilization between production apparatus employing nozzles according to the invention and production apparatus employing related-art nozzles | | | | |
|---|---|---|---|---|
| | Amount of raw materials used | Film thickness | Light transmittance | Sheet resistance |
| Production apparatus of the invention | 0.6 g | 1.2 µm | 88 % | 6.5 Ω/□ |
| Related-art production apparatus | 1.0 g | 1.2 µm | 88 % | 7.5 Ω/□ |

. As shown in Table 1, it was found that the composite nozzles 4A according to the invention are superior in the efficiency of raw-material utilization to the nozzles in a related-art film deposition apparatus.

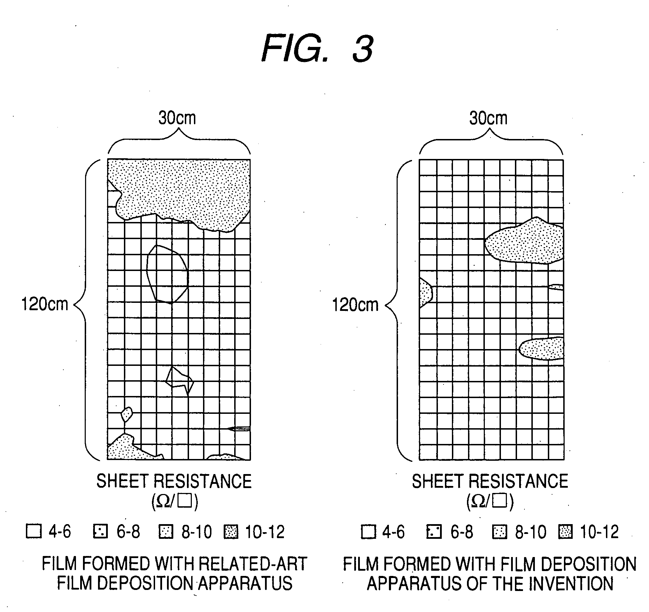

Fig. 3 shows a comparison in film properties of a transparent conductive film (distribution of sheet resistance) between the case where a transparent conductive film was formed with the film deposition apparatus for the continuous formation of a multilayered transparent conductive film of the invention using the setter made of a carbon composite having high thermal conductivity and the case where a transparent conductive film was formed with a related-art film deposition apparatus in which a substrate was directly set on a hot plate for heating. As shown in Fig. 3, it was found that the transparent conductive film formed using the setter made of a carbon composite in the film deposition apparatus for the continuous formation of a multilayered transparent conductive film of the invention has more even film properties (distribution of sheet resistance) than in the case where a substrate is directly set on a hot plate for heating in a related-art film deposition apparatus. Incidentally, the sheet resistance is evenly distributed in the range of 6-8 [Ω/□].

Table 2 given below shows a comparison in substrate treatment rate between the case where a transparent conductive film was formed with the film deposition apparatus for the continuous formation of a multilayered transparent conductive film of the invention in which the charging part 3 and the takeout part 5 were equipped with a preheating mechanism 3A and a substrate-cooling mechanism 5A, respectively, and the case where a transparent conductive film was formed with a related-art film deposition apparatus.

**[Table 2]**

| Comparison in substrate treatment rate between production apparatus of the invention and related-art production apparatus | | | |
|---|---|---|---|
| | Substrate size | Film deposition time | Time period required for operation other than film deposition |
| Production apparatus of the invention | 30 cm×120 cm | 7 min | 0.5 min |
| Related-art production apparatus | 30 cm×120 cm | 16 min | 30 min |

As shown in Table 2, it was found that the film deposition apparatus for the continuous formation of a multilayered transparent conductive film of the invention attains a shorter film deposition time than the related-art film deposition apparatus.

Table 3 given below shows a comparison in solar cell characteristics between a CIS type thin-film solar cell employing a transparent conductive film formed with the film deposition apparatus for the continuous formation of a multilayered transparent conductive film of the invention and a CIS type thin-film solar cell employing a transparent conductive film formed with the related-art film deposition apparatus.

**[Table 3]**

| Comparison in solar cell characteristics between CIS type thin-film solar cell produced with production apparatus of the invention and CIS type thin-film solar cell produced with related-art production apparatus (integrated structure; 30 cm × 120 cm size) | | | | |
|---|---|---|---|---|
| | Conversion effciency [%] | Curvature factor | Open-circuit voltage [V] | Short-circuit current density [mA/cm²] |
| Production apparatus of the invention | 13.2 | 0.66 | 0.57 | 35.1 |
| Related-art production apparatus | 12.6 | 0.63 | 0.57 | 35.1 |

As shown in Table 3, it was found that the film deposition apparatus for the continuous formation of a multilayered transparent conductive film of the invention attains better solar cell characteristics than the related-art film deposition apparatus.

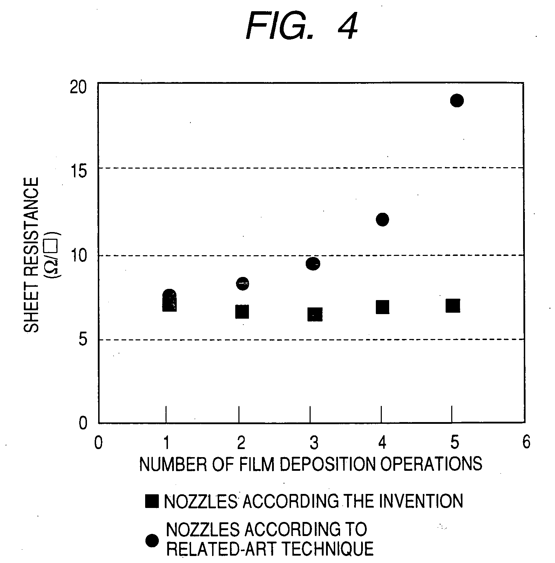

Furthermore, Fig. 4 shows the relationship between film quality (sheet resistance) and the number of film deposition operations in the case where transparent conductive films were continuously formed with the nozzles according to the invention and in the case where transparent conductive films were batchwise formed with the related-art nozzles.

A comparison between the sheet resistances of the transparent conductive films in the case where film deposition was repeatedly conducted batchwise using the related-art nozzles (see Fig. 6) and those in the case where film deposition was continuously conducted using the nozzles according to the invention (see Fig. 2) proved the following. In the case where the related-art nozzles are used, as the number of film deposition operations increases, the nozzles are heated and raw-material feeding onto the substrate decreases, resulting in a decrease in film thickness and hence in an increase in the sheet resistance of the transparent conductive film as shown in Fig. 4. There has hence been a problem that the solar cell has a reduced conversion efficiency. In contrast, in the case where film deposition is continuously conducted with the nozzles according to the invention, the sheet resistance of the transparent conductive film is constant due to the nozzle-cooling mechanism.

### BRIEF DESCRIPTION OF THE DRAWINGS

[Fig. 1] Fig. 1 is a view showing the constitution of a film deposition apparatus of the invention for the continuos formation of a multilayered transparent conductive film.
[Fig. 2] Fig. 2 is a view showing the constitution of the composite nozzles disposed in each of the deposition treatment parts in the multilayer deposition treatment part of the film deposition apparatus of the invention for the continuous formation of a multilayered transparent conductive film.
[Fig. 3] Fig. 3 is views showing a comparison in film properties of a transparent conductive film (distribution of sheet resistance) between the case where a transparent conductive film was formed with the film deposition apparatus for the continuous formation of a multilayered transparent conductive film of the invention using the setter made of a carbon composite having high thermal conductivity and the case where a transparent conductive film was formed with a related-art film deposition apparatus in which a substrate was directly set on a hot plate for heating.
[Fig. 4] Fig. 4 is a presentation showing the relationship between film quality and the number of repetitions of film deposition in transparent conductive films formed with the nozzles according to the invention and in transparent conductive films formed with related-art nozzles.
[Fig. 5] Fig. 5 is a view showing the constitution of a related-art MOCVD apparatus.
[Fig. 6] Fig. 6 is a view showing the structure of the nozzles of the related-art MOCVD apparatus.

### DESCRIPTION OF THE REFERENCE NUMERALS AND SINGS

1 film deposition apparatus for continuous formation of multilayered transparent conductive film
2 substrate attachment part
3 charging part
3A preheating mechanism
4 multilayer deposition treatment part
41 deposition treatment part
4n deposition treatment part
4A composite nozzle
4a ejection nozzle for organometallic compound and diborane
4b water ejection nozzle
4c cooling pipe
5 takeout part
5A substrate-cooling mechanism
6 substrate detachment part
7 setter return part
7a setter
A substrate

## Claims

1. An apparatus comprising a film-deposition, chamber for producing a transparent conductive film comprising an n-type semiconductor on a substrate by metal-organic chemical vapour deposition (MOCVD) in which an organometallic compound, diborane (B₂H₆) and water are reacted in a vapour phase while heating the substrate, the film-deposition chamber comprising:
a group of nozzles which are arranged in the same plane and comprise pipe-form nozzles having ejection holes for simultaneously or separately spraying the organometallic compound, diborane and pure water, the pipe-form nozzles being arranged adjacent to each other such that there is no space between them; and
a nozzle-cooling means comprising cooling pipes disposed between nozzles of the planar group of nozzles such that there is no space between the cooling pipes and the nozzles.

2. An in-line type film-deposition apparatus for the continuous production of a multilayered transparent conductive film, the apparatus comprising:
a substrate-attachment part comprising a setter for attaching a substrate thereto;
a charging part for evacuating the air around the substrate attached to the setter;
a multilayer deposition treatment part comprising two or more deposition treatment parts for forming a multilayered transparent conductive film comprising an n-type semiconductor on the substrate by metal-organic chemical vapour deposition (MOCVD) in which an organometallic compound, diborane (B₂H₆) and water are reacted in a vapour phase while heating the substrate;
a takeout part for returning the substrate having the multilayered transparent conductive film thereon to atmospheric pressure;
a substrate-detachment part for detaching the substrate having the multilayered transparent conductive film thereon from the setter; and
a setter-return part for returning the detached setter to the substrate-attachment part;
wherein:
the apparatus is capable of conducting film-deposition while moving the substrate sequentially through said parts to form the multilayered transparent conductive film; and
each deposition-treatment part comprises a group of nozzles which are arranged in the same plane and comprise pipe-form nozzles having ejection holes for simultaneously or separately spraying the organometallic compound, diborane and pure water, the pipe-form nozzles being arranged adjacent to each other such that there is no space between them; and
each deposition-treatment part comprises a nozzle-cooling means which comprises cooling pipes disposed between nozzles of the planar group of nozzles such that there is no space between the cooling pipes and the nozzles.

3. An apparatus according to Claim 2, wherein the charging part comprises a substrate-preheating means and the takeout part comprises a substrate-cooling means.

4. An apparatus according to Claim 2, wherein the setter is a production jig for fixing the substrate and conveying it through each part of the apparatus, and the setter comprises a member which contains a thermally-conductive carbon composite, a nickel coating on the member and a pin for fixing the substrate.

## Patentansprüche

1. Vorrichtung, umfassend eine Filmabscheidungskammer zur Herstellung eines transparenten, leitfähigen Films, der einen n-Typ-Halbleiter umfasst, auf einem Substrat durch metallorganische chemische Gasphasenabscheidung (MOCVD), worin eine organometallische Verbindung, Diboran (B₂H₆) und Wasser in der Gasphase umgesetzt werden, während das Substrat erwärmt wird, wobei die Abscheidungskammer umfasst:
Eine Gruppe von Düsen, die in der gleichen Ebene angeordnet sind, und röhrenförmige Düsen umfassen, welche Ausstoßlöcher zum simultanen oder separaten Sprühen der organometallischen Verbindung, von Diboran und reinem Wasser aufweisen, worin die röhrenförmigen Düsen zueinander benachbart angeordnet sind, so dass kein Abstand zwischen ihnen vorliegt; und
ein Düsenkühlmittel, umfassend Kühlröhren, die zwischen den Düsen der planaren Gruppe von Düsen so angeordnet sind, dass kein Abstand zwischen den Kühlröhren und den Düsen vorliegt.

2. Filmabscheidungsvorrichtung vom In-Line-Typ für die kontinuierliche Herstellung eines mehrschichtigen transparenten leitfähigen Films, worin die Vorrichtung umfasst:
einen Substrat-Verbindungsteil, umfassend einen Setter zum Verbinden eines Substrats hiermit;
ein Ladeteil zum Evakuieren der Luft um das Substrat, das mit dem Setter verbunden ist;
einen Multischicht-Abscheidungsbehandlungsteil, umfassend zwei oder mehr Abscheidungsbehandlungsteile zum Bilden eines mehrschichtigen transparenten leitfähigen Films, der einen n-Typ-Halbleiter umfasst, auf einem Substrat durch metallorganische chemische Gasphasenabscheidung (MOCVD), worin eine organometallische Verbindung, Diboran (B₂H₆) und Wasser in der Gasphase umgesetzt werden, während das Substrat erwärmt wird;
einen Herausnahmeteil zum Rückführen des Substrats mit dem mehrschichtigen transparenten leitfähigen Film hierauf auf Umgebungsdruck;
einen Substrat-Ablöseteil zum Ablösen des Substrats mit dem mehrschichtigen transparenten leitfähigen Film hierauf von dem Setter; und
einen Setter-Rückleitweg zum Rückleiten des abgelösten Setters zu dem Substrat-Verbindungsteil;
worin:
die Vorrichtung in der Lage ist, eine Filmabscheidung durchzuführen, während das Substrat sequentiell durch die Teile durchgeführt wird, um den mehrschichtigen transparenten leitfähigen Film zu bildenden; und
jedes Abscheidungsbehandlungsteil eine Gruppe von Düsen umfasst, die in der gleichen Ebene angeordnet sind und röhrenförmige Düsen mit Ausstoßlöchern zum simultanen oder separaten Sprühen der organometallischen Verbindung, von Diboran und von reinem Wasser umfassen, worin die röhrenförmigen Düsen aneinander angrenzend so angeordnet sind, dass kein Abstand zwischen ihnen vorliegt; und
jedes Abscheidungsbehandlungsteil ein Düsenkühlmittel umfasst, welches Kühlröhren umfasst, die zwischen den Düsen der planaren Gruppe von Düsen so angeordnet sind, dass kein Abstand zwischen den Kühlröhren und den Düsen vorliegt.

3. Vorrichtung gemäß Anspruch 2, worin das Ladeteil ein Substrat-Vorheizmittel umfasst und das Herausnahmeteil ein Substrat-Kühlmittel umfasst.

4. Vorrichtung gemäß Anspruch 2, worin der Setter eine Produktionsspannvorrichtung zum Fixieren des Substrats und Befördern hiervon durch jeden Teil der Vorrichtung ist, und der Setter ein Bauteil umfasst, das ein thermisch leitfähiges Kohlenstoffkomposit, eine Nickelbeschichtung auf dem Bauteil und einen Pin zum Fixieren des Substrats enthält.

## Revendications

1. Appareil comprenant une chambre de dépôt de film pour fabriquer un film conducteur transparent comprenant un semi-conducteur de type n sur un substrat par dépôt chimique métallo-organique en phase vapeur (MOCVD) dans lequel un composé organométallique, du diborane (B₂H₆), et de l'eau sont mis à réagir dans une phase vapeur tout en chauffant le substrat, la chambre de dépôt de film comprenant :
un groupe de buses qui sont agencées dans le même plan et comprennent des buses en forme de tuyau ayant des trous d'éjection pour pulvériser simultanément ou séparément le composé organométallique, le diborane et l'eau pure, les buses en forme de tuyau étant disposées adjacentes les unes aux autres de sorte qu'il n'y ait pas d'espace entre elles ; et
des moyens de refroidissement de buse comprenant des tuyaux de refroidissement disposés entre des buses du groupe planaire de buses de sorte qu'il n'y ait pas d'espace entre les tuyaux de refroidissement et les buses.

2. Appareil de dépôt de film de type en ligne pour la fabrication continue d'un film conducteur transparent multicouche, l'appareil comprenant :
une partie de fixation de substrat comprenant un support pour y attacher un substrat ;
une partie d'alimentation pour évacuer l'air autour du substrat attaché au support;
une partie de traitement de dépôt multicouche comprenant deux ou parties de traitement de dépôt ou plus pour former un film conducteur transparent multicouche comprenant un semi-conducteur de type n sur le substrat par dépôt chimique métallo-organique en phase vapeur (MOCVD) dans lequel un composé organométallique, du diborane (B₂H₆), et de l'eau sont mis à réagir dans une phase vapeur tout en chauffant le substrat;
une partie d'évacuation pour remettre le substrat portant le film conducteur transparent multicouche à la pression atmosphérique ;
une partie de détachement de substrat pour détacher le substrat portant le film conducteur transparent multicouche du support ; et
une partie de retour de support pour retourner le support détaché dans la partie de fixation de substrat ;
dans lequel :
l'appareil est capable de réaliser un dépôt de film tout en déplaçant le substrat séquentiellement à travers lesdites parties pour former le film conducteur transparent multicouche; et
chaque partie de traitement de dépôt comprend un groupe de buses qui sont agencées dans le même plan et comprennent des buses en forme de tuyau ayant des trous d'éjection pour pulvériser simultanément ou séparément le composé organométallique, le diborane et l'eau pure, les buses en forme de tuyau étant disposées adjacentes les unes aux autres de sorte qu'il n'y ait pas d'espace entre elles ; et
chaque partie de traitement de dépôt comprend des moyens de refroidissement de buse qui comprennent des tuyaux de refroidissement disposés entre des buses du groupe planaire de buses de sorte qu'il n'y ait pas d'espace entre les tuyaux de refroidissement et les buses.

3. Appareil selon la revendication 2, dans lequel la partie d'alimentation comprend des moyens de préchauffage de substrat et la partie d'évacuation comprend des moyens de refroidissement de substrat.

4. Appareil selon la revendication 2, dans lequel le support est un support de fabrication permettant de fixer le substrat et de le transporter à travers chaque partie de l'appareil, et le support comprend un élément qui contient un composite de carbone thermiquement conducteur, un revêtement de nickel sur l'élément et une broche pour fixer le substrat.
